# EUROPEAN PATENT APPLICATION

(11) **EP 2 645 423 A1**
(43) Date of publication of application: **02.10.2013**
(21) Application number: 11843258.2
(22) Date of filing: 10.11.2011
(51) Int. Cl.: H01L 31/042, C09J 9/02

(54) **CONDUCTIVE ADHESIVE MATERIAL, SOLAR CELL MODULE, AND METHOD FOR MANUFACTURING SAME**

(30) Priority: 26.11.2010 JP 2010263607
(71) Applicant: Dexerials Corporation, Tokyo 141-0032 (JP)
(72) Inventor: NAKAHARA, Koichi, Tokyo 141-0032 (JP)
(74) Representative: Müller - Hoffmann & Partner
(86) International application number: PCT/JP2011/075935
(87) International publication number: WO 2012/070396

(57) **Abstract**

The present invention provides a conductive adhesive material by which high connection reliability is obtained, a solar cell module, and a manufacturing method for the same. The conductive adhesive material (20) contains a film-forming resin, a liquid epoxy resin, a curing agent, and conductive particles, and an acid anhydride-based curing agent or phenol-based curing agent is used as the curing agent, and solder particles are used for the conductive particles. The solder is wet and spread by the flux effect of the curing agent, and high contact reliability is obtained.

## Description

### Field of the Invention

This invention relates to a conductive adhesive material in which conductive particles are dispersed and a solar cell module that connects surface/rear surface electrodes of solar cells and tab wires by using such an adhesive material as well as a method for manufacturing the same. The present application asserts priority rights based on JP Patent Application 2010-263607 filed in Japan on November 26, 2010. The total contents of disclosure of the Patent Application of the senior filing date are to be incorporated by reference into the present Application.

### Background of the Invention

Conventionally, in a crystal silicon-based solar cell module, a plurality of adjacent solar cells are connected to one another by using a tab wire made of a ribbon-shaped copper foil coated with solder. The tab wire has its one end connected to a surface electrode of one of solar cells, with the other end being connected to a rear surface electrode of another adjacent solar cell, so that the respective solar cells are series-connected to one after another.

More specifically, with respect to the connection between the solar cell and the tab wire, a busbar electrode formed on a light-receiving surface of a solar cell by using a screen printing process of silver paste, as well as an Ag electrode formed on a rear surface connection portion of the solar cell, and a tab wire are connected to each other by a solder plating process. Additionally, Al electrodes are formed on a region other than the connection portion on the rear surface of each solar cell.

However, in the case of soldering, since the connection process is carried out at a high temperature exceeding 200°C, there might be a problem with connection reliability between the surface electrode as well as the rear surface electrode of the solar cell and the tab wire due to a warping of the solar cell, an inner stress caused in the connection portion between the tab wire and the surface electrode as well as the rear surface electrode, and flux residues, etc.

For this reason, as a connection method between the tab wire and the surface electrode as well as the rear surface electrode of a solar cell, a method has been proposed in which a conductive adhesive film, which can be connected by a thermal press-bonding process at a comparatively low temperature, is used (for example, see Patent Documents 1 and 2).

### Prior-Art Documents

### Patent Document

PTL 1: Japanese Patent Application Laid-Open No. 2007-214533
PTL 2: Japanese Patent Application Laid-Open No. 2008-135652

### Summary of the Invention

However, in a conventional conductive adhesive film for a solar cell module, a metal filler is used as conductive particles, and since such a metallic bond to an electrode as to be formed by a solder plating is not formed, poor connection reliability might be caused.

The present invention has been devised in view of these conventional problems, and its object is to provide a conductive adhesive material by which high connection reliability can be obtained, and a method for manufacturing such an adhesive material, and also to provide a solar cell module and a method for manufacturing such a module.

The present inventors extensively studied to find that by using solder particles as conductive particles for use in a conductive adhesive material, as well as using an acid anhydride-based curing agent or a phenol-based curing agent as a curing agent, high connection reliability can be obtained.

That is, the conductive adhesive material in accordance with the present invention contains a film-forming resin, a liquid-state epoxy resin, a curing agent and conductive particles, and is characterized in that the curing agent is an acid anhydride-based curing agent or a phenol-based curing agent, with solder particles being used as the conductive particles.

Moreover, a solar cell module in accordance with the present invention having a structure in which a surface electrode of one of solar cells is electrically connected to a rear surface electrode of another solar cell that is adjacent to the one solar cell by a tab wire via a conductive adhesive material is characterized in that the conductive adhesive material contains a forming resin, a liquid-state epoxy resin, a curing agent and conductive particles, and in that the curing agent is an acid anhydride-based curing agent or a phenol-based curing agent, with the conductive particles being prepared as solder particles.

Furthermore, a method for manufacturing a solar cell module in accordance with the present invention, which relates to a manufacturing method for a solar cell module in which a surface electrode of one of solar cells is electrically connected to a rear surface electrode of another solar cell that is adjacent to the one solar cell by a tab wire via a conductive adhesive material, is characterized in that the conductive adhesive material contains a forming resin, a liquid-state epoxy resin, a curing agent and conductive particles, and in that the curing agent is an acid anhydride-based curing agent or a phenol-based curing agent, with the conductive particles being prepared as solder particles, and in that the method is provided with the steps of: temporarily disposing the surface electrode of the one of the solar cells and the tab wire as well as disposing the rear surface electrode of the other solar cell and the tab wire, with the conductive adhesive materials being respectively interpolated therebetween; and press-bonding the upper surface of the tab wire by using a thermal pressing head.

A method for manufacturing a solar cell module in accordance with the present invention, which relates to a manufacturing method for a solar cell module in which a surface electrode of one of solar cells is electrically connected to a rear surface electrode of another solar cell that is adjacent to the one solar cell by a tab wire via a conductive adhesive material, is characterized in that the conductive adhesive material contains a forming resin, a liquid-state epoxy resin, a curing agent and conductive particles, and in that the curing agent is an acid anhydride-based curing agent or a phenol-based curing agent, with the conductive particles being prepared as solder particles, and in that the method is provided with the steps of: temporarily disposing the surface electrode of the one of the solar cells and the tab wire as well as disposing the rear surface electrode of the other solar cell and the tab wire, with the conductive adhesive materials being respectively interpolated therebetween; after stacking a sealing member and a protective base member successively on the upper and lower surfaces of the solar cell, laminating and press-bonding from the upper surface of the protective base member by using a laminating device so that the sealing member is cured and the surface electrode and the tab wire, as well as the rear surface electrode and the tab wire, are also connected to each other.

### Effects of the Invention

In accordance with the present invention, by using solder particles as conductive particles for a conductive adhesive material as well as using an acid anhydride-based curing agent or a phenol-based curing agent as a curing agent, a wet spreading state of solder is improved so that since a firm metallic bond is formed, high connection reliability can be obtained.

### Brief Description of Drawings

Figure 1 is an exploded perspective view showing a structure of a solar cell module in accordance with a first embodiment to which the present invention is applied.
Figure 2 is a cross-sectional view showing a solar cell module.
Figure 3 is a cross-sectional view showing a low pressure laminator.

### Detailed Description of the Invention

Referring to Figures, the following description will discuss embodiments of the present invention in the following order in detail.
1. Conductive Adhesive Material
2. Solar Cell Module
3. Method for Manufacturing Solar Cell Module
4. Examples

### <1. Conductive Adhesive Material>

First, the following description will discuss a conductive adhesive material for use in electrically connecting a surface electrode or a rear surface electrode of solar cells and a tab wire. Additionally, the shape of the conductive adhesive material is not limited to a film shape, and a paste may be used.

The conductive adhesive material in the present embodiment contains a film-forming resin, a liquid-state epoxy resin, a curing agent and conductive particles, and as the curing agent, an acid anhydride-based curing agent or a phenol-based curing agent is used, and solder particles are used as the conductive particles.

The film-forming resin corresponds to a high-molecular-weight resin having an average molecular weight of 10000 or more, and from the viewpoint of a film forming characteristic, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., a phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the curing agent, an acid anhydride-based curing agent or a phenol-based curing agent is used. These curing agents have a flux effect for improving a wet expanding characteristic of a solder, and since these also react with an epoxy component upon curing, it is possible to prevent bad influences caused by residues of the curing agent.

As the acid anhydride-based curing agent, an alicyclic acid anhydride, an aromatic acid anhydride, fatty acid anhydride, etc. may be used. Among these, an alicyclic acid anhydride having a norbornene skeleton is desirably used. As such an alicyclic acid anhydride, methylbicyclo[2,2,1]heptane-2,3-dicarboxylic acid anhydride/bicyclo[2,2,1]heptane-2,3,-dicarboxylic acid anhydride represented by the following formula is proposed.

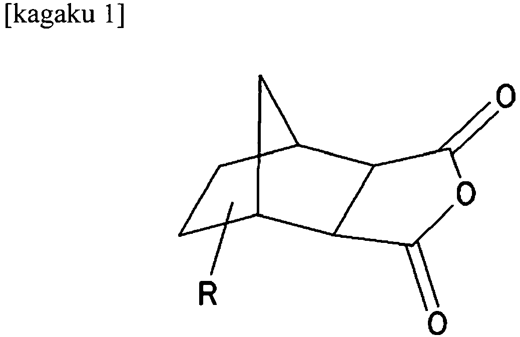

### (in the formula, R represents a hydrogen atom or a methyl group.)

Additionally, a curing agent having a free carboxylic acid is undesirable because it has a high reactivity and causes a reduction in the life of a conductive adhesive material.

Moreover, as the phenol-based curing agent, a phenol formaldehyde-type novolak resin, a phenol aralkyl-type novolak resin, etc. may be used.

As the conductive particles, solder particles of an eutectic solder, a low melting point solder to which Bi, or In is added, or the like, which are used for connection by a thermal press-bonding process at a comparatively low temperature, are preferably used. The melting point of the solder particles is determined on demand depending on an initial temperature of the curing agent, and from the viewpoints of warping of a solar cell and an inner stress caused in a connection portion between a tab wire and a surface/rear surface electrode, it is preferably set in a range from 100°C or more to 200°C or less, more preferably, from 135°C or more to 150°C or less.

With respect to the relationship between the solder particles and the curing agent, the curing initial temperature of the curing agent is preferably made higher than the melting point of the solder particles. With this arrangement, after the curing agent is allowed to exert a sufficient flex function, the curing agent and epoxy can be cured. Moreover, these can be desirably used in a laminate press-bonding process to be described later in which the curing process of the sealing resin and connection between an electrode and a tab wire are carried out simultaneously.

Furthermore, the absolute value of a difference between the curing initial temperature of the curing agent and the melting point of the solder particles is preferably set to 35°C or less, more preferably, to 15°C or less. When the temperature difference becomes greater than this, the flux effect becomes insufficient, resulting in degradation in connection reliability.

Moreover, as other additive compositions, rubber-based flexible particles, such as acrylic rubber (ACR), butadiene rubber (BR), nitrile rubber (NBR), and the like, are preferably blended. Since the flexible particles make it possible to absorb the inner stress without causing any curing inhibition, it is possible to provide high connection reliability.

Furthermore, a silane coupling agent may be added. As the silane coupling agent, epoxy-based, amino-based, mercapto-sulfide based, ureide-based agents and the like may be used. Thus, the adhesive property of an interface between an organic material and an inorganic material can be improved.

In accordance with such a conductive adhesive material, a firm metallic bond can be formed between a tab wire and an electrode by using a thermal press-bonding process at a comparatively low temperature, thereby making it possible to obtain high connection reliability.

Upon preparing a conductive adhesive material having the above-mentioned composition, a forming resin, a liquid-state epoxy resin, a curing agent and conductive particles are dissolved in a solvent. As the solvent, toluene, ethyl acetate, or the like, or a mixture of these may be used.

Moreover, upon producing a sheet-shaped conductive conduction film, a resin composition, prepared by dissolving the forming resin, the liquid-state epoxy resin, the curing agent and the conductive particles in a solvent, is applied onto a peeling base member by using a bar coater, a coating device, or the like, and the composition on the peeling base member is dried by using a heating oven, a heating drier, or the like so that a conductive conduction film having a predetermined thickness can be obtained.

The peeling base member has a laminate structure in which a peeling agent such as silicone is applied to PET (Poly Ethylene Terephthalate), OPP (Oriented Polypropylene), PMP (Poly-4-methylpentene-1), PTFE (Polytetrafluoroethylene), or the like so that the conductive conduction film can be prevented from drying, while maintaining its shape.

### <2. Solar Cell Module>

Referring to Figs., the following description will discuss a solar cell module to which the present invention is applied and a method for manufacturing such a solar cell module, in detail. The solar cell module 1 to which the present invention is applied is a crystal silicon-based solar cell module using a single-crystal-type silicon photoelectric conversion element and a polycrystal-type silicon photoelectric conversion element as its photoelectric conversion element, and a thin-film silicon-based solar cell which uses a photoelectric conversion element in which a cell made of amorphous silicon and a cell made of fine crystal silicon and amorphous silicon germanium are stacked.

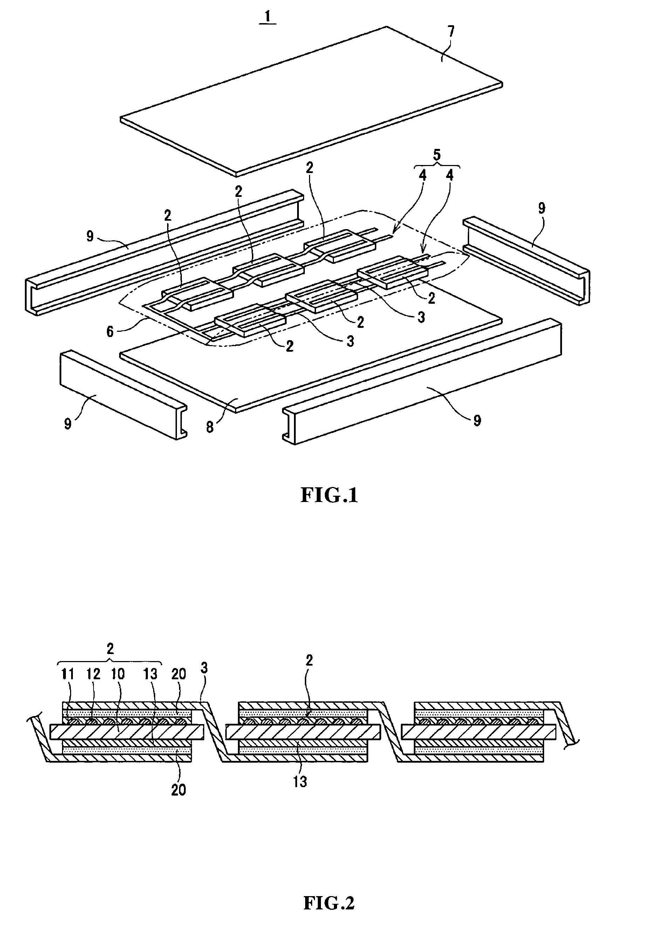

As shown in Fig. 1, the solar cell module 1 is provided with strings 4, each having a plurality of solar cells 2 that are series-connected with one after another via tab wires 3 serving as interconnectors, and a matrix 5 in which a plurality of these strings 4 are arranged. Moreover, the solar cell module 1 is formed through processes in which each matrix 5 is sandwiched by sheets 6 made of a sealing adhesive agent, and integrally laminated together with a surface cover 7 formed on a light receiving surface side as a protective substrate and a back sheet 8 formed on the rear surface side, and lastly, a metal frame 9 such as aluminum or the like is attached to the periphery thereof.

As the sealing adhesive agent, for example, a translucent sealing material, such as, for example, ethylene vinyl alcohol (EVA), is used. Moreover, as the surface cover 7, a translucent material, for example, such as glass, a translucent plastic material, or the like, is used. As the back sheet 8, a laminate or the like in which glass or an aluminum foil is sandwiched by resin films is used.

As shown in Fig. 2, each of the solar cells 2 of the solar cell module has a photoelectric conversion element 10 made of a silicon substrate. The photoelectric conversion element 10 has a structure in which a busbar electrode 11, which forms a surface electrode, and finger electrodes 12, which are collector electrodes formed in a direction virtually orthogonal to the buabar electrode 11, are formed on the light-receiving surface side. Moreover, in the photoelectric conversion element 10, an Al rear surface electrode 13 made of aluminum is formed on the rear surface side opposed to the light receiving surface.

Furthermore, in the solar cell 2, the busbar electrode 11 on the surface is electrically connected to the Al rear surface electrode 13 of an adjacent solar cell 2 with a tab wire 3 so that the strings 4 that are series connected to one after another are formed. Connections among the tab wires 3, the busbar electrodes 11 and the Al rear surface electrodes 13 are made by using a conductive adhesive film 20.

As the tab wire 3, tab wires that have been used in conventional solar cell modules may be utilized. The tab wire 3 is formed by using, for example, a ribbon-shaped copper foil having, for example, a thickness in a range from 50µm to 300µm, on which a gold plating, silver plating, tin plating, or solder plating process, or the like is carried out, if necessary. Moreover, a wire on which a conductive adhesive film has been preliminarily stacked may be used as the tab wire 3.

The busbar electrode 11 is formed by applying an Ag paste thereto and heating the paste. The busbar electrode 11, formed on the light-receiving surface of the solar cell 2, is formed into a line shape with a width of, for example, 1 mm, so as to reduce an area blocking incident light and consequently to suppress a shadow loss. The number of the busbar electrodes 11 is determined on demand by taking into consideration the size and resistance of the solar battery cell 2.

The finger electrodes 12 are formed by using the same method as that of the busbar electrodes 11 over virtually the entire surface of the light-receiving surface of the solar battery cell 2 in a manner so as to cross the busbar electrodes 11. Moreover, the finger electrodes 12 have such an arrangement that lines, each having a width of about 100µm, are formed with predetermined intervals, for example, every other 2 mm.

The Al rear surface electrode 13 is prepared as an electrode made of aluminum, which is formed on the rear surface of the solar cell 2 by using, for example, a screen printing method, a sputtering method, or the like.

Additionally, the solar cell 2 is not necessarily provided with the busbar electrodes 11. In this case, the solar cell 2 has such a structure that electric currents of the finger electrodes 12 are collected by tab wires 3 that cross the finger electrodes 12. Moreover, the Al rear surface electrode 13 may have openings in such an extent as not to cause connection failure relative to the tab wires, and with this structure, a sufficient adhesion strength may be ensured.

### <3. Method for Manufacturing Solar Cell Module>

Referring to Fig. 1, the following description will discuss a method for manufacturing a solar cell module. The method for manufacturing a solar cell module in accordance with a first embodiment, which is a method for manufacturing a solar cell module in which a surface electrode of one solar cell is electrically connected to a rear surface of another solar cell adjacent to the one solar cell via a conductive adhesive film by using a tab wire, is designed such that the surface electrode of the one solar cell and the tab wire as well as the rear surface electrode and the tab wire of the other solar cell are temporarily disposed with the above-mentioned conductive adhesive films interpolated therebetween, and a press-bonding process is carried out by a thermal press-bonding head from the upper surface of the tab wire.

More specifically, first, an Ag paste is applied onto the surface of a photoelectric conversion element 10 and by carrying out a baking process thereon, finger electrodes 12 and busbar electrodes 11 are formed, and on the rear surface, an Al rear surface electrode 13 is formed on a connection portion of the tab wires 3 by using an Al screen method or the like; thus, a solar cell is manufactured.

Next, onto the busbar electrodes 11 on the surface of the photoelectric conversion element 10 and the Al rear surface electrode 13 on the rear surface, conductive adhesive films 20 are pasted, with tab wires 3 being arranged on these conductive adhesive films 20.

Then, a thermal press-bonding process is carried out on the tab wires 3 at a predetermined pressure so that the tab wires 3, the busbar electrodes 11 and the Al rear surface electrode 13 are electrically connected to one another. At this time, the tab wires 3 can be firmly connected to the busbar electrodes 11 mechanically because the binder resin of the conductive adhesive film 20 has a superior adhesive property to the busbar electrodes 11 in which the binder resin of the conductive adhesive film 20 is formed by the Ag paste. Moreover, the tab wires 3 are electrically connected to the Al rear surface electrode 13.

The solar cell module 1 is manufactured by processes in which the matrix 5 having the solar cells 2 connected therein is sandwiched by the sealing adhesive sheets 6 and this is subjected to a laminating process integrally with the surface cover 7 formed on the light-receiving side as the protective member and the back sheet 8 formed on the rear surface side.

In the first embodiment, since the above-mentioned conductive adhesive film contains a forming resin, a liquid-state epoxy resin, a curing agent and conductive particles, with the curing agent being prepared as an acid anhydride-based curing agent or a phenol-based curing agent and with the conductive particles being prepared as solder particles, a firm metallic bond can be formed between the tab wires and the electrodes by a thermal press-bonding process at a comparatively low temperature of 200°C or less at the time of a press-bonding process by the use of a thermal press-bonding head, thereby making it possible to obtain high connection reliability.

Next, the following description will discuss a method for manufacturing a solar cell module in accordance with a second embodiment in which the curing process of the sealing resin and connections between electrodes and tab wires are simultaneously carried out. The method for manufacturing a solar cell module in accordance with the second embodiment, which is a method for manufacturing a solar cell module in which a surface electrode of one solar cell is electrically connected to a rear surface of another solar cell adjacent to the one solar cell via a conductive adhesive film by using a tab wire, is designed such that the surface electrode of the one solar cell and a tab wire, as well as the rear surface electrode of the other solar cell and a tab wire, are temporarily secured, with the above-mentioned conductive adhesive films interpolated therebetween, and a sealing material and a protective base member are successively stacked on each of the upper and lower surfaces of the solar cell, and a laminate press-bonding process is carried out by a laminating device from the upper surface of the protective base member so that the sealing material is cured while the surface electrodes and the tab wire as well as the rear surface electrodes and the tab wire are simultaneously connected to each other.

First, the following description will discuss the laminating device that simultaneously carries out the curing process of the sealing resin and the connecting process between the electrodes and the tab wires.

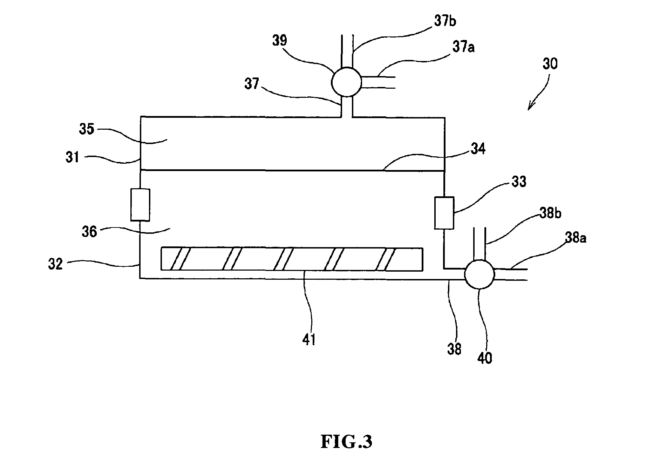

Fig. 3 is a view that shows a structure of a low pressure laminator. The low pressure laminator 30 is constituted by an upper unit 31 and a lower unit 32. These units are separatably formed into one unit, with a sealing member 33 such as an O-ring interpolated therebetween. An flexible sheet 34, such as a silicon rubber, is disposed on the upper unit 31, and the low pressure laminator 30 is divided into a first chamber 35 and a second chamber 36 by this flexible sheet 34.

Moreover, to each of the upper unit 31 and the lower unit 32, pipings 37 and 38 are attached so as to adjust the inner pressure of each chamber independently, that is, so as to adjust each chamber to a reduced pressure, an increased pressure, or further to a pressure opened to atmosphere, by a vacuum pump, a compressor, or the like. The piping 37 is branched by a switching valve 39 into a pipe 37a and a pipe 37b in two directions, and the piping 38 is branched by a switching valve 40 into a pipe 38a and a pipe 38b in two directions. Moreover, a stage 41, which can be heated, is installed in the lower unit 32.

Next, the following description will discuss a specific connection method in which the low pressure laminator 30 is used. First, the upper unit 31 and the lower unit 32 are separated from each other, and on the stage 41, a laminate in which a sealing member and protective base members (surface cover 7, back sheet 8) are successively stacked on each of the upper and lower surfaces of a solar cell on which the tab wires have been temporarily secured is mounted. Additionally, the temperature at the time when the tab wires are temporarily secured onto the solar cells may be lower than a melting point of the solder particles of the conductive adhesive material.

Then, the upper unit 31 and the lower unit 32 are separatably formed into one unit via a sealing member 33, and thereafter, a vacuum pump is connected to each of the pipe 37a and the pipe 38a so that the first chamber 35 and the second chamber 36 are brought into a highly vacuumed state. With the inside of the second chamber 36 being kept in the highly vacuumed state, the switching valve 39 is switched so that the air is introduced into the first chamber 35 from the pipe 37b. Thus, the flexible sheet 34 is expanded toward the second chamber 36, with the result that the laminate is compressed by the flexible sheet 34 while being heated by the stage 41.

After the thermal press-bonding process, the switching valve 40 is switched so that the air is introduced into the second chamber 36 from the pipe 38b. Thus, the flexible sheet 34 is pressed to return toward the first chamber 35, with the result that the inner pressures of the first chamber 35 and the second chamber 36 are finally made equal to each other.

Lastly, the upper unit 31 and the lower unit 32 are separated from each other, and a solar cell module that has been subjected to the thermal press-bonding process is taken out from the stage 41. Thus, the curing process of the sealing resin and the connecting process between the electrodes and the tab wires can be simultaneously carried out.

In the second embodiment, by setting a thermal press-bonding temperature in the laminate device higher than the melting temperature of solder particles of the conductive adhesive material, a firm metallic bond can be formed between the tab wires and the electrodes, thereby making it possible to obtain high connection reliability. Moreover, by using a conductive adhesive material in which a curing agent has a curing start temperature higher than the melting point of the solder particles, after allowing the curing agent to exert a sufficient flex function, the curing agent and epoxy can be cured. Furthermore, by using a conductive adhesive material in which the curing start temperature and the melting point of the solder particles have a difference of 15°C or less, a sufficient flux effect is obtained so that the connection reliability can be improved.

### EXAMPLES

### <4. Examples>

The following description will discuss examples of the present invention; however, the present invention is not intended to be limited by these examples. In these examples, as shown in the following examples 1 to 6 and comparative examples 1 to 3, the surface and rear surface electrodes of solar cells and tab wires are connected to each other by using a conductive adhesive film, and the bonding property, adhesive property and connection reliability were evaluated.

### [Evaluation of Bonding Property]

In order to evaluate the flux functions, by pulling and peeling the electrodes of a solar cell and the tab wires away from each other, wet and spreading state of the solder was observed by an optical microscope. In the evaluation shown in Tables 1 and 2, those solders having a wet and spreading area of 3.0 times or more in area ratio from the original area were evaluated as "⊚", those having a wet and spreading area in a range from 1.5 times or more to 3.0 times or less in area ratio from the original area were evaluated as "○", those having a wet and spreading area of less than 1.5 times in area ratio from the original area were evaluated as "Δ", and those having no wet and spreading area from the original area were evaluated as "×".

### [Evaluation of Adhesive Property]

Each tab wire of the solar cell was raised in a direction of 90° relative to the electrode surface by using a tensile tester (Tensilon made by Orientec Co., Ltd.) so that the adhesive strength was measured. In evaluations shown in Tables 1 and 2, those having an adhesive strength of 2.0 N/mm or more were evaluated as evaluated as "⊚", those having an adhesive strength in a range from 1.5 N/mm or more to 2.0 N/mm or less were evaluated as "○", those having an adhesive strength in a range from 1.0 N/mm or more to 1.5 N/mm or less were evaluated as "Δ", and those having an adhesive strength of less than 1.0 N/mm were evaluated as "×".

### [Evaluation of Connection Reliability]

With respect to the solar cell, the initial resistance and a resistance after a TH test (Thermal Humidity Test) at a temperature of 85°C and a humidity of 85%RH for 500 hours were measured. In the measurements, the connection resistance was measured by a four-terminal method using a digital multimeter (Digital Multimeter 7555, made by Yokogawa Electric Corporation) with application of electric current of 1 mA. In the evaluations shown in Tables 1 and 2, the connection resistance of less than 4 Ω was evaluated as "⊚", the connection resistance in a range from 4 Ω or more to 5 Ω or less was evaluated as "○", the connection resistance in a range from 5 Ω or more to 6 Ω or less was evaluated as "Δ", and the connection resistance of 6 Ω or more was evaluated as "×".

### [Example 1]

The following components were blended with one another so that a conductive adhesive material was prepared: phenoxy resin (YD-50, made by New Nippon Steel Chemical Co., Ltd.)(20 parts by mass), liquid-state epoxy resin (EP828, made by Mitsubishi Chemical Corp.)(30 parts by mass), acid anhydride-based curing agent (HNA-100, made by New Japan Chemical Co., Ltd.)(20 parts by mass), acrylic rubber (Teisan Resin SG80H, made by Nagase Chemtex Corporation)(15 parts by mass), polybutadiene rubber (RKB Series, made by Resinous Kasei Co., Ltd.)(15 parts by mass) and Sn-In (52%)-based solder particles (melting point: 117°C, made by Senju Metal Industry Co., Ltd.)(30 parts by mass). This material is applied onto a PET base that has been subjected to a peeling treatment by using a bar coater, and this was dried at 80°C for 5 minutes in an oven so that a conductive adhesive film having a thickness of 25µm was produced.

Next, the adhesive conductive films were pasted onto a surface electrode portion made of Ag and a rear surface portion made of A1 of a 6-inch polycrystal Si cell (dimension: 15.6 cm × 15.6 cm, thickness: 180µm), and a Cu tab wire (width: 2 mm, thickness: 0.15 mm) coated with solder was thermally pressed onto each of the conductive adhesive films (140°C, 15 seconds, 2 MPa) by using a heater head so as to be temporarily secured thereon.

Moreover, the solar cell with the tab wire temporarily secured thereon was sandwiched by sheets with a sealing adhesive agent, and this was integrally laminated together with the surface cover formed on the light-receiving surface side and the back sheet formed on the rear surface side. More specifically, after both of the pressures of the first chamber 35 and the second chamber 36 had been reduced to 133 Pa, with the heating stage of the second chamber 36 of the low pressure laminator 30 shown in FIG. 3 being maintained at 155°C, the air was introduced into the first chamber 35 to be kept at the atmospheric pressure. After having been kept in this state for 5 minutes, the air was introduced into the second chamber 36 so as to be kept at the atmospheric pressure.

The evaluation results of the bonding property of these solar cell modules were given as "○", the evaluation results of the adhesive property were given as "○", and the evaluation results of the connection reliability were given as "○" in the initial stage, and also given as "Δ" after the TH test. These results are shown in Table 1.

### [Example 2]

The same processes as those of example 1 were carried out except that Sn-Bi (58%)-based solder particles (melting point: 139°C, made by Senju Metal Industry Co., Ltd.) were used so that a conductive adhesive film was produced. By using this conductive adhesive film, the same processes as those of example 1 were carried out so that a solar cell module was produced.

The evaluation results of the bonding property of these solar cell modules were given as "○", the evaluation results of the adhesive property were given as "○", and the evaluation results of the connection reliability were given as "⊚" in the initial stage, and also given as "○" after the TH test. These results are shown in Table 1.

### [Example 3]

The same processes as those of example 1 were carried out except that Sn-Bi (50%)-based solder particles (melting point: 150°C, made by Senju Metal Industry Co., Ltd.) were used so that a conductive adhesive film was produced. By using this conductive adhesive film, the same processes as those of example 1 were carried out so that a solar cell module was produced.

The evaluation results of the bonding property of these solar cell modules were given as "⊚", the evaluation results of the adhesive property were given as "⊚", and the evaluation results of the connection reliability were given as "⊚" in the initial stage, and also given as "⊚" even after the TH test. These results are shown in Table 1.

### [Example 4]

The same processes as those of example 1 were carried out except that Sn-Pb (37%)-based solder particles (melting point: 183°C, made by Senju Metal Industry Co., Ltd.) were used so that a conductive adhesive film was produced.

Moreover, the same processes as those of example 1 were carried out except that the thermal press-bonding process was executed at a temperature of 180°C at the time of the temporarily securing process so that a solar cell module was produced.

The evaluation results of the bonding property of these solar cell modules were given as "○", the evaluation results of the adhesive property were given as "○", and the evaluation results of the connection reliability were given as "○" in the initial stage, and also given as "Δ" after the TH test. These results are shown in Table 1.

### [Example 5]

The same processes as those of example 1 were carried out except that in place of the acid anhydride-based curing agent, phenol-based curing agent (TD-2131, made by DIC Corp.) was used, with Sn-Bi (50%)-based solder particles (melting point: 150°C, made by Senju Metal Industry Co., Ltd.) being used, so that a conductive adhesive film was produced. By using this conductive adhesive film, the same processes as those of example 1 were carried out so that a solar cell module was produced.

The evaluation results of the bonding property of these solar cell modules were given as "Δ", the evaluation results of the adhesive property were given as "Δ", and the evaluation results of the connection reliability were given as "○" in the initial stage, and also given as "Δ" after the TH test. These results are shown in Table 1.

### [Example 6]

The same processes as those of example 1 were carried out except that Sn-Pb (37%)-based solder particles (melting point: 183°C, made by Senju Metal Industry Co., Ltd.) were used so that a conductive adhesive film was produced.

Moreover, the same processes as those of example 4 were carried out except that the thermal press-bonding process was executed at a temperature of 180°C at the time of the temporarily securing process and that the heating stage of the second chamber 36 of the low pressure laminator 30 shown in Fig. 3 was maintained at 200°C so that a solar cell module was produced.

The evaluation results of the bonding property of these solar cell modules were given as "Δ", the evaluation results of the adhesive property were given as "○", and the evaluation results of the connection reliability were given as "○" in the initial stage, and also given as "Δ" after the TH test. These results are shown in Table 1.

**[Table 1]**

| | | Example 1 | Example 2 | Example 3 | Example 4 | Example 5 | Example 6 |
|---|---|---|---|---|---|---|---|
| Curing agent | | Acid anhydride-type | Acid anhydride-type | Acid anhydride-type | Acid anhydride-type | Phenol-type | Acid anhydride-type |
| Curing start temperature of curing agent (°C) | | 150 | 150 | 150 | 150 | 140 | 150 |
| Solder particles (kinds) | | Sn-52In | Sn-58Bi | Sn-50Bi | Sn-37Pb | Sn-50Bi | Sn-37Pb |
| Melting point of solder particles (°C) | | 117 | 139 | 150 | 183 | 150 | 183 |
| (Temporarily) Securing temperature | | 140 | 140 | 140 | 180 | 140 | 180 |
| Laminate temperature | | 155 | 155 | 155 | 155 | 155 | 200 |
| Bonding property | | ○ | ○ | ⊚ | ○ | Δ | Δ |
| Adhesive property | | ○ | ○ | ⊚ | ○ | Δ | ○ |
| Connection reliability | Initial | ○ | ⊚ | ⊚ | ○ | ○ | ○ |
| | 85°C85%RH 500hr | Δ | ○ | ⊚ | Δ | Δ | Δ |

### [Comparative Example 1]

The same processes as those of example 1 were carried out except that in place of the acid anhydride-based curing agent, organic acid dihydrazide-based curing agent (AMICURE UDH-J, made by Ajinomoto Fine-Techno Co., Inc.) was used, with Sn-Bi (50%)-based solder particles (melting point: 150°C, made by Senju Metal Industry Co., Ltd.) being used, so that a conductive adhesive film was produced. By using this conductive adhesive film, the same processes as those of example 1 were carried out so that a solar cell module was produced.

The evaluation results of the bonding property of these solar cell modules were given as "×", the evaluation results of the adhesive property were given as "Δ", and the evaluation results of the connection reliability were given as " × " in the initial stage, and also given as "×" after the TH test. These results are shown in Table 2.

### [Comparative Example 2]

The same processes as those of example 1 were carried out except that in place of the acid anhydride-based curing agent, imidazole-based curing agent (NOVACURE HX3941HP, made by Asahi-Kasei E-materials Corp.) was used, with Sn-Bi (50%)-based solder particles (melting point: 150°C, made by Senju Metal Industry Co., Ltd.) being used, so that a conductive adhesive film was produced. By using this conductive adhesive film, the same processes as those of example 1 were carried out so that a solar cell module was produced.

The evaluation results of the bonding property of these solar cell modules were given as "×", the evaluation results of the adhesive property were given as "Δ", and the evaluation results of the connection reliability were given as "X" in the initial stage, and also given as "×" after the TH test. These results are shown in Table 2.

**[Table 2]**

| | | Comparative Example 1 | Comparative Example 2 |
|---|---|---|---|
| Curing agent | | Organic acid dihydrazide-type | Imidazole-type |
| Curing start temperature of curing agent (°C) | | 150 | 120 |
| Solder particles (kinds) | | Sn-50Bi | Sn-50Bi |
| Melting point of solder particles (°C) | | 150 | 150 |
| Temporarily securing temperature | | 140 | 140 |
| Laminate temperature | | 155 | 155 |
| Bonding property | | × | × |
| Adhesive property | | Δ | Δ |
| Connection reliability | Initial | × | × |
| | 85°C85%RH 500hr | × | × |

In comparative example 1 using the organic acid dihydrazide-based curing agent and comparative example 2 using the imidazole-based curing agent, no wet spreading state of solder was observed, failing to provide good connection reliability. In contrast, in examples 1 to 4 and 6 using the acid anhydride-based curing agent and example 5 using the phenol-based curing agent, a wet spreading state of solder was observed. That is, it is found that in accordance with examples 1 to 6, since the flux functions are exerted in the conductive adhesive film using solder particles, good connection reliability can be obtained.

In accordance with examples 1 to 3, it is found that by using a connection method in which the curing process of a sealing resin and the connection between the electrodes and the tab wires are carried out simultaneously, good connection reliability can be obtained. Moreover, in accordance with examples 4 and 6, it is found that by connecting the electrodes and the tab wires at the time of a (temporarily) securing process by using a thermal press-bonding head, good connection reliability can also be obtained.

Moreover, by setting a difference between the curing start temperature of the curing agent and the melting point of the solder particles to 15°C or less, high evaluation results were obtained with respect to all the bonding property, adhesive property and connection reliability (examples 2 and 3).

### Reference Signs List

1...solar cell module, 2...solar cell, 3...tab wire, 4...strings, 5...matrix, 6...sheet, 7...surface cover, 8...back sheet, 9...metal frame, 10...photoelectric conversion element, 11...busbar electrode, 12...finger electrode, 13...A1 rear surface electrode, 20...conductive adhesive film, 30...low pressure laminator, 31... upper unit, 32...lower unit, 33...sealing member, 34...flexible sheet, 35...first chamber, 36...second chamber, 37, 38...piping, 39, 40...switching valve, 41 stage

## Claims

1. A conductive adhesive material comprising:
a film-forming resin, a liquid-state epoxy resin, a curing agent and conductive particles, wherein the curing agent is an acid anhydride-based curing agent or a phenol-based curing agent, and the conductive particles are solder particles.

2. The conductive adhesive material according to claim 1, wherein the curing agent is an acid anhydride-based curing agent, with the acid anhydride-based curing agent being prepared as an alicyclic acid anhydride having a norbornane skeleton.

3. The conductive adhesive material according to claim 1 or 2, wherein the curing agent has a curing start temperature that is a melting temperature of the solder particles or more.

4. The conductive adhesive material according to claim 3, wherein the curing start temperature of the curing agent and the melting point of the solder particles have a difference of 15°C or less.

5. The conductive adhesive material according to claim 3 or 4, wherein the melting point of the solder particles is in a range from 135°C or more to 150°C or less.

6. A solar cell module comprising:
a surface electrode of one of solar cells that is electrically connected to a rear surface electrode of another solar cell that is adjacent to the one solar cell by a tab wire via a conductive adhesive material,
wherein the conductive adhesive material contains a forming-resin, a liquid-state epoxy resin, a curing agent and conductive particles, and the curing agent is an acid anhydride-based curing agent or a phenol-based curing agent, with the conductive particles being prepared as solder particles.

7. A method for manufacturing a solar cell module comprising the steps of:
electrically connecting a surface electrode of one of solar cells to a rear surface electrode of another solar cell that is adjacent to the one solar cell by a tab wire via a conductive adhesive material,
wherein the conductive adhesive material contains a forming-resin, a liquid-state epoxy resin, a curing agent and conductive particles, and the curing agent is an acid anhydride-based curing agent or a phenol-based curing agent, with the conductive particles being prepared as solder particles, and
wherein the method further comprises the steps of:
temporarily disposing the surface electrode of the one of the solar cells and the tab wire as well as disposing the rear surface electrode of the other solar cell and the tab wire, with the conductive adhesive materials being respectively interpolated therebetween; and
press-bonding the upper surface of the tab wire by using a thermal pressing head.

8. A method for manufacturing a solar cell module comprising the steps of:
electrically connecting a surface electrode of one of solar cells to a rear surface electrode of another solar cell that is adjacent to the one solar cell by a tab wire via a conductive adhesive material,
wherein the conductive adhesive material contains a forming-resin, a liquid-state epoxy resin, a curing agent and conductive particles, and the curing agent is an acid anhydride-based curing agent or a phenol-based curing agent, with the conductive particles being prepared as solder particles, and
wherein the method further comprises the steps of:
temporarily disposing the surface electrode of the one of the solar cells and the tab wire as well as disposing the rear surface electrode of the other solar cell and the tab wire, with the conductive adhesive materials being respectively interpolated therebetween; and
after stacking a sealing member and a protective base member successively on the upper and lower surfaces of the solar cell, laminating and press-bonding from the upper surface of the protective base member by using a laminating device so that the sealing member is cured and the surface electrode and the tab wire, as well as the rear surface electrode and the tab wire, are also connected to each other.

9. The method for manufacturing a solar cell module according to claim 8, wherein the laminating and press-bonding process has a temperature that is the melting temperature of the solder particles or more.
